# EUROPEAN PATENT APPLICATION

(11) **EP 3 690 476 A1**
(43) Date of publication of application: **05.08.2020**
(21) Application number: 19154167.1
(22) Date of filing: 29.01.2019
(51) Int. Cl.: G01S 7/52, H03G 1/00

(54) **TIME GAIN COMPENSATION CIRCUIT AND METHOD, FOR USE IN ULTRASOUND IMAGING**

(71) Applicant: Koninklijke Philips N.V., 5656 AG Eindhoven (NL)
(72) Inventor: MOUNAIM, Amine, 5656 AE Eindhoven (NL); VAN RENS, Antonia Cornelia, 5656 AE Eindhoven (NL); DOUGLAS, Alexander Ulrich, 5656 AE Eindhoven (NL)
(74) Representative: de Haan, Poul Erik

(57) **Abstract**

A time gain compensation circuit for an ultrasound imaging system uses a resistor network in a negative feedback path of a ultrasound receive amplifier. Shorting switches are used to change the feedback resistance and they are controlled by ramp signals. For one or more of the switch control circuits, a low slope first ramp signal is generated during an initial ramp period and steep slope second ramp signal is generated during a following ramp period for controlling the switching of the shorting switch. A shallow ramp is thus used to implement a desired progressive switching function whereas a steep ramp avoids a long start up delay. In this way the gain has a more linear response over time but a long start up time period is avoided.

## Description

### FIELD OF THE INVENTION

The invention relates to ultrasound imaging, and in particular relates to a time gain compensation circuit and method used in ultrasound imaging.

### BACKGROUND OF THE INVENTION

Ultrasound imaging, in particular medical ultrasound imaging, is a widely-used diagnostic technique that enables visualization of internal organs, their size, structure, and blood flow estimation.

An ultrasound system uses a focal imaging technique that involves time shifting, scaling, and intelligently summing the echo energy using an array of transducers to achieve high imaging performance. The concept of focal point imaging provides the ability to focus on a single point in the scan region. By subsequently focusing at different points, an image is assembled. When initiating an imaging procedure, a pulse is generated and transmitted from multiple transducer elements. The pulse, in the form of an acoustic energy, propagates through the body as sound waves, typically in the frequency range of 1 MHz to 30 MHz. The sound waves are attenuated as they travel through the objects being imaged. Most medical ultrasound systems use the reflection imaging mode. As the signal travels, portions of the wave front energy are reflected back towards the transducer.

Signals that are reflected immediately after transmission are very strong because they are from reflections close to the surface, whereas reflections that occur long after the transmit pulse are very weak because they are reflecting from deep in the body. As a result of the limitations on the amount of energy that can be put into the imaging object, extremely sensitive receive electronics has been developed with wide dynamic range.

Received echoes from focal points close to the surface require little, if any, amplification. This region is referred to as the near field. However, echoes received from focal points deep in the body are extremely weak and must be amplified by a factor of 100 or more. This region is referred to as the far field.

The analog front end receiver has this unique challenge. It needs to be capable to adapt to both the weak (far field) and strong (near field) received signals. This means that any strong echo must be conditioned so as to not saturate and distort the receive chain and any weak echo must be amplified while introducing minimal noise to enable the source of the echo to be determined.

For this purpose, most analog front end receivers consist of a low noise amplifier (LNA) whose gain is programmable. The function of increasing and decreasing the gain is termed Time Gain Control (TGC).

One approach for providing time gain control is to provide a variable resistor in a negative feedback path of an amplifier, thereby setting the gain of the overall amplifier circuit.

It is desirable to control the variable resistor, and hence the overall amplifier gain, in a stepwise manner rather than in a continuous analogue manner, since this allows more accurate and faster digital control, and simpler implementation. For example, the gain control may be implemented by using digitally controlled transistor switching circuits to control the configuration of a resistor network. However, stepwise changes in gain will result in image artefacts. For example a staircase type gain profile will generate higher frequency spurs in the spectrum which will distort the received signal. Thus, switching the gain quickly causes artefacts, but slowing down the switching creates unwanted delays and signal distortion.

There is therefore a need for a time gain compensation circuit which can be implemented with simple circuitry but which avoids sharp stepwise changes in gain which can result in image artefacts.

### SUMMARY OF THE INVENTION

The invention is defined by the claims.

According to examples in accordance with an aspect of the invention, there is provided a time gain compensation circuit for an ultrasound imaging system, comprising:
a resistor network for forming a negative feedback path of a ultrasound receive amplifier, wherein the resistor network comprises a set of resistors and a set of shorting switches each for shorting a respective one or ones of the resistors;
a switch control circuit for each shorting switch for generating a ramp signal for providing progressive switching of the respective shorting switch,
wherein at least one of the switch control circuits comprises:
   a ramp generator for generating a first ramp signal during an initial ramp period and a second, less steep, ramp signal during a following ramp period, wherein the second ramp signal controls the switching of the shorting switch.

By "progressive switching" is meant that there is a slope in the control voltage applied to the shorting switch when switching takes place, so that the switching is deliberately not instantaneous, but takes place over a time period.

The total time gain compensation period may for example be of the order of hundreds of ns or one to tens of µs (for example 500ns to 10µs). For 15 such control ramps, each ramp (or each portion of the ramp corresponding to the voltage at which switching of the shorting switch takes place) for example has a duration of at least 10ns (for example so that of an overall 500ns time period 150ns is allocated to the progressive switching of the shorting switches, assuming 15 of them).

Thus, the time taken to switch between on and off (or vice versa) may be more than 5ns, for example more than 10ns, for example more than 20ns.

Thus, the progressive switching is essentially an analog control of the switching function so that it is deliberately extended over a time period longer than would be the case with a simple step change in the switch control signal.

The use of two ramp signals enables a shallow ramp to be used to implement the desired progressive switching function whereas a steep ramp avoids a long delay from the initial startup of the time gain compensation circuit until the progressive switching is initiated. In this way, the gain has a more linear response over time but a long start up time period is avoided. This provides a desired compromise between distortion, delay and image artefacts.

The at least one of the switch control circuits may comprise:
a controllable current source;
a capacitor which is charged or discharged by the current from the controllable current source; and
a controller for controlling the current source to operate at a first current to generate the first ramp signal and at a second, lower, current to generate the second ramp signal.

In this way, a controllable current source is used to implement the change in ramp slope.

The at least one of the switch control circuits may then comprise:
a level detector for detecting a level of the first ramp signal for switching from the first current to the second current.

In particular, when the first ramp signal is approaching the level at which the progressive switching will take place, the ramp slope is reduced, so that the switching function is made more gradual.

The resistor network for example comprises a series connection of resistors, each having an associated shorting switch and switch control circuit, wherein each switch control circuit is initiated by a signal from a preceding switch control circuit.

By shorting resistors in a series chain, the overall resistance is reduced (and hence the gain is reduced) by shorting resistors. The aim is for example to achieve an increasing gain over time. Thus, the controllable resistors may all be shorted initially, and over time the shorting switches are opened to gradually increase the resistance and hence increase the gain.

The at least one of the switch control circuits may comprise a second level detector for detecting a level of the first or second ramp signals for triggering the initiation of a subsequent switch control circuit. In this way, separate control is not needed for each switch control circuit. Instead, a single start signal may be provided, and the circuit then implements a sequential operation of the switch control circuits to achieve the desired gain function with respect to time. Switch control circuits may not necessarily be triggered by the immediately preceding switch control circuit, but may be triggered by switch control circuits further back in the series.

The circuit may comprise:
a first sub-set of shorting switches and an associated first sub-set of switch control circuits which comprise said at least one of the switch control circuits; and
a second sub-set of shorting switches and an associated second sub-set of switch control circuits, wherein the second sub-set of switch control circuits each comprise a ramp generator for generating a single ramp signal.

In this way, not all the switch control circuits need to implement the double ramp. The overall circuit complexity is reduced by providing only the first-to-be-used switch control circuits with the double ramp, because these are the ones which would otherwise introduce an initial startup delay. Distortion is reduced by minimizing the amount of switching operations.

Each shorting switch for example comprises a transistor or a transistor circuit, wherein the second ramp signal crosses the switching threshold of the transistor or transistor circuit. This provides operation in the linear region of the shorting switch, and hence essentially implements analog switch control.

The invention also provides an ultrasound receive amplifier, comprising:
an amplifier circuit; and
a time gain compensation circuit as defined above, with the resistor network of the time gain compensation circuit forming a negative feedback path of the amplifier circuit.

The invention also provides an ultrasound transceiver, comprising:
an ultrasound receive amplifier as defined above;
an ultrasound transmit amplifier; and
a transmit/receive switch for selectively coupling an ultrasound transducer to the ultrasound receive amplifier and the ultrasound transmit amplifier.

The invention also provides an ultrasound system, comprising:
an ultrasound transceiver as defined above; and
an ultrasound transducer coupled to the ultrasound receive amplifier and the ultrasound transmit amplifier through the transmit/receive switch.

The invention also provides a time gain compensation method for an ultrasound system, comprising:
generating ramp signals using switch control circuits, wherein each switch control circuit is associated with a respective shorting switch for shorting a respective resistor or resistors of a resistor network forming a negative feedback path of a ultrasound receive amplifier;
wherein for at least one of the switch control circuits, the method comprises:
   generating a first ramp signal during an initial ramp period;
   generating a second, less steep, ramp signal during a following ramp period; and
   controlling the switching of the shorting switch using the second ramp signal.

This method uses a ramp signal with shallow steepness for switching a shorting switch but avoids a time delay by using a steeper ramp signal before the shorting function commences.

For said at least one of the switch control circuits, the method for example comprises:
controlling a current source to operate at a first current to generate the first ramp signal and at a second, lower, current to generate the second ramp signal; and
charging or discharging a capacitor using the current from the controllable current source.

The resistor network may comprise a series connection of resistors, each having an associated shorting switch and switch control circuit, wherein the method comprises initiating each switch control circuit by a signal from a preceding switch control circuit. Thus, a daisy-chain type control approach is adopted.

Said at least one of the switch control circuits may comprise a first sub-set of switch control circuits and the method comprises, for a second sub-set of shorting switches, generating a single ramp signal.

This simplifies the required circuitry in that the double ramp signal is only used when it is needed to reduce start up times.

Each shorting switch may comprise a transistor or a transistor circuit, wherein the method comprises generating the second ramp signal to cross the switching threshold of the transistor or transistor circuit.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Figure 1 is used to explain general operation of an exemplary ultrasound system;
Figure 2 shows a known configuration of the parts of the ultrasound system relevant to the invention;
Figure 3 shows an example of the variable resistor used in Figure 2;
Figure 4 shows a time gain compensation circuit according to one example of the invention;
Figure 5 shows one example of the first two switch control circuits of Figure 4;
Figure 6 shows a resistance versus voltage characteristic curve;
Figure 7 shows the capacitor voltages over time for a set of switch control
Figure 8 shows another possible example of the first two switch control circuits of Figure 4;
Figure 9 shows the overall impedance of the feedback resistor over time for different cases; and
Figure 10 shows a time gain compensation method.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides a time gain compensation circuit for an ultrasound imaging system, which uses a resistor network in a negative feedback path of an ultrasound receive amplifier. Shorting switches are used to change the feedback resistance and they are controlled by ramp signals. For one or more of the switch control circuits, a low slope first ramp signal is generated during an initial ramp period and steep slope second ramp signal is generated during a following ramp period for controlling the switching of the shorting switch. A shallow ramp is thus used to implement a desired progressive switching function whereas a steep ramp avoids a long start up delay. In this way the gain has a more linear response over time but a long start up time period is avoided.

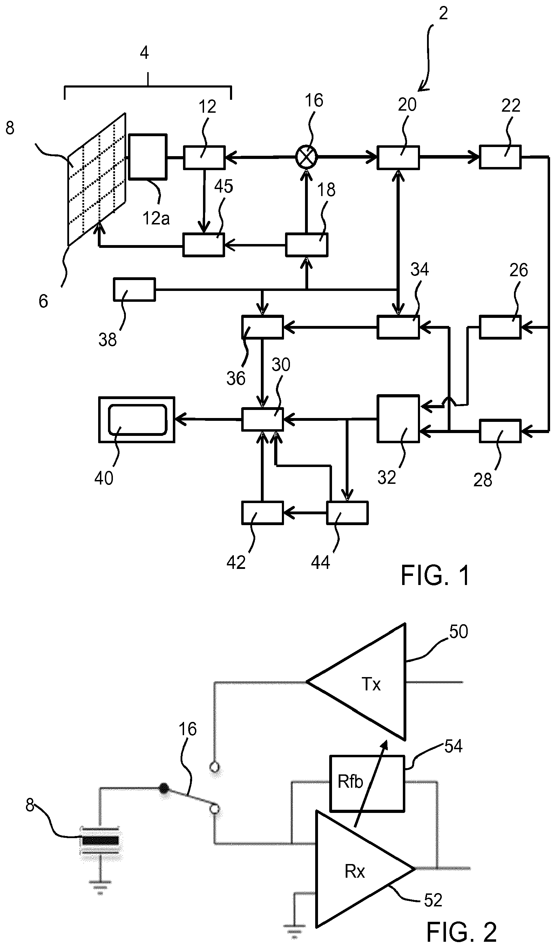

Before describing the invention, the general operation of an exemplary ultrasound system will first be described, with reference to Figure 1, and with emphasis on the signal processing function of the system since this invention relates to the processing of the signals measured by the transducer array.

The system comprises an array transducer probe 4 which has a transducer array 6 for transmitting ultrasound waves and receiving echo information. The transducer array 6 may comprise CMUT transducers; piezoelectric transducers, formed of materials such as PZT or PVDF; or any other suitable transducer technology. In this example, the transducer array 6 is a two-dimensional array of transducers 8 capable of scanning either a 2D plane or a three dimensional volume of a region of interest. In another example, the transducer array may be a 1D array.

The transducer array 6 is coupled to a microbeamformer 12 which controls reception of signals by the transducer elements. Microbeamformers are capable of at least partial beamforming of the signals received by sub-arrays, generally referred to as "groups" or "patches", of transducers as described in US Patents 5,997,479 (Savord et al.), 6,013,032 (Savord), and 6,623,432 (Powers et al.).

It should be noted that the microbeamformer is entirely optional. Further, the system includes a transmit/receive (T/R) switch 16, which the microbeamformer 12 can be coupled to and which switches the array between transmission and reception modes, and protects the main beamformer 20 from high energy transmit signals in the case where a microbeamformer is not used and the transducer array is operated directly by the main system beamformer. The transmission of ultrasound beams from the transducer array 6 is directed by a transducer controller 18 coupled to the microbeamformer by the T/R switch 16 and a main transmission beamformer (not shown), which can receive input from the user's operation of the user interface or control panel 38. The controller 18 can include transmission circuitry arranged to drive the transducer elements of the array 6 (either directly or via a microbeamformer) during the transmission mode.

In a typical line-by-line imaging sequence, the beamforming system within the probe may operate as follows. During transmission, the beamformer (which may be the microbeamformer or the main system beamformer depending upon the implementation) activates the transducer array, or a sub-aperture of the transducer array. The sub-aperture may be a one dimensional line of transducers or a two dimensional patch of transducers within the larger array. In transmit mode, the focusing and steering of the ultrasound beam generated by the array, or a sub-aperture of the array, are controlled as described below.

Upon receiving the backscattered echo signals from the subject, the received signals undergo receive beamforming (as described below), in order to align the received signals, and, in the case where a sub-aperture is being used, the sub-aperture is then shifted, for example by one transducer element. The shifted sub-aperture is then activated and the process repeated until all of the transducer elements of the transducer array have been activated.

For each line (or sub-aperture), the total received signal, used to form an associated line of the final ultrasound image, will be a sum of the voltage signals measured by the transducer elements of the given sub-aperture during the receive period. The resulting line signals, following the beamforming process below, are typically referred to as radio frequency (RF) data. Each line signal (RF data set) generated by the various sub-apertures then undergoes additional processing to generate the lines of the final ultrasound image. The change in amplitude of the line signal with time will contribute to the change in brightness of the ultrasound image with depth, wherein a high amplitude peak will correspond to a bright pixel (or collection of pixels) in the final image. A peak appearing near the beginning of the line signal will represent an echo from a shallow structure, whereas peaks appearing progressively later in the line signal will represent echoes from structures at increasing depths within the subject.

One of the functions controlled by the transducer controller 18 is the direction in which beams are steered and focused. Beams may be steered straight ahead from (orthogonal to) the transducer array, or at different angles for a wider field of view. The steering and focusing of the transmit beam may be controlled as a function of transducer element actuation time.

Two methods can be distinguished in general ultrasound data acquisition: plane wave imaging and "beam steered" imaging. The two methods are distinguished by a presence of the beamforming in the transmission ("beam steered" imaging) and/or reception modes (plane wave imaging and "beam steered" imaging).

Looking first to the focusing function, by activating all of the transducer elements at the same time, the transducer array generates a plane wave that diverges as it travels through the subject. In this case, the beam of ultrasonic waves remains unfocused. By introducing a position dependent time delay to the activation of the transducers, it is possible to cause the wave front of the beam to converge at a desired point, referred to as the focal zone. The focal zone is defined as the point at which the lateral beam width is less than half the transmit beam width. In this way, the lateral resolution of the final ultrasound image is improved.

For example, if the time delay causes the transducer elements to activate in a series, beginning with the outermost elements and finishing at the central element(s) of the transducer array, a focal zone would be formed at a given distance away from the probe, in line with the central element(s). The distance of the focal zone from the probe will vary depending on the time delay between each subsequent round of transducer element activations. After the beam passes the focal zone, it will begin to diverge, forming the far field imaging region. It should be noted that for focal zones located close to the transducer array, the ultrasound beam will diverge quickly in the far field leading to beam width artifacts in the final image. Typically, the near field, located between the transducer array and the focal zone, shows little detail due to the large overlap in ultrasound beams. Thus, varying the location of the focal zone can lead to significant changes in the quality of the final image.

It should be noted that, in transmit mode, only one focus may be defined unless the ultrasound image is divided into multiple focal zones (each of which may have a different transmit focus).

In addition, upon receiving the echo signals from within the subject, it is possible to perform the inverse of the above described process in order to perform receive focusing. In other words, the incoming signals may be received by the transducer elements and subject to an electronic time delay before being passed into the system for signal processing. The simplest example of this is referred to as delay-and-sum beamforming. It is possible to dynamically adjust the receive focusing of the transducer array as a function of time.

Looking now to the function of beam steering, through the correct application of time delays to the transducer elements it is possible to impart a desired angle on the ultrasound beam as it leaves the transducer array. For example, by activating a transducer on a first side of the transducer array followed by the remaining transducers in a sequence ending at the opposite side of the array, the wave front of the beam will be angled toward the second side. The size of the steering angle relative to the normal of the transducer array is dependent on the size of the time delay between subsequent transducer element activations.

Further, it is possible to focus a steered beam, wherein the total time delay applied to each transducer element is a sum of both the focusing and steering time delays. In this case, the transducer array is referred to as a phased array.

In case of the CMUT transducers, which require a DC bias voltage for their activation, the transducer controller 18 can be coupled to control a DC bias control 45 for the transducer array. The DC bias control 45 sets DC bias voltage(s) that are applied to the CMUT transducer elements.

For each transducer element of the transducer array, analog ultrasound signals, typically referred to as channel data, enter the system by way of the reception channel. In the reception channel, partially beamformed signals are produced from the channel data by the microbeamformer 12 and are then passed to a main receive beamformer 20 where the partially beamformed signals from individual patches of transducers are combined into a fully beamformed signal, referred to as radio frequency (RF) data. The beamforming performed at each stage may be carried out as described above, or may include additional functions. For example, the main beamformer 20 may have 128 channels, each of which receives a partially beamformed signal from a patch of dozens or hundreds of transducer elements. In this way, the signals received by thousands of transducers of a transducer array can contribute efficiently to a single beamformed signal.

The beamformed reception signals are coupled to a signal processor 22. The signal processor 22 can process the received echo signals in various ways, such as: band-pass filtering; decimation; I and Q component separation; and harmonic signal separation, which acts to separate linear and nonlinear signals so as to enable the identification of nonlinear (higher harmonics of the fundamental frequency) echo signals returned from tissue and micro-bubbles. The signal processor may also perform additional signal enhancement such as speckle reduction, signal compounding, and noise elimination. The band-pass filter in the signal processor can be a tracking filter, with its pass band sliding from a higher frequency band to a lower frequency band as echo signals are received from increasing depths, thereby rejecting noise at higher frequencies from greater depths that is typically devoid of anatomical information.

The beamformers for transmission and for reception are implemented in different hardware and can have different functions. Of course, the receiver beamformer is designed to take into account the characteristics of the transmission beamformer. In Figure 1 only the receiver beamformers 12, 20 are shown, for simplicity. In the complete system, there will also be a transmission chain with a transmission micro beamformer, and a main transmission beamformer.

The function of the micro beamformer 12 is to provide an initial combination of signals in order to decrease the number of analog signal paths. This is typically performed in the analog domain.

The final beamforming is done in the main beamformer 20 and is typically after digitization.

The transmission and reception channels use the same transducer array 6 which has a fixed frequency band. However, the bandwidth that the transmission pulses occupy can vary depending on the transmission beamforming used. The reception channel can capture the whole transducer bandwidth (which is the classic approach) or, by using bandpass processing, it can extract only the bandwidth that contains the desired information (e.g. the harmonics of the main harmonic).

The RF signals may then be coupled to a B mode (i.e. brightness mode, or 2D imaging mode) processor 26 and a Doppler processor 28. The B mode processor 26 performs amplitude detection on the received ultrasound signal for the imaging of structures in the body, such as organ tissue and blood vessels. In the case of line-by-line imaging, each line (beam) is represented by an associated RF signal, the amplitude of which is used to generate a brightness value to be assigned to a pixel in the B mode image. The exact location of the pixel within the image is determined by the location of the associated amplitude measurement along the RF signal and the line (beam) number of the RF signal. B mode images of such structures may be formed in the harmonic or fundamental image mode, or a combination of both as described in US Pat. 6,283,919 (Roundhill et al.) and US Pat. 6,458,083 (Jago et al.) The Doppler processor 28 processes temporally distinct signals arising from tissue movement and blood flow for the detection of moving substances, such as the flow of blood cells in the image field. The Doppler processor 28 typically includes a wall filter with parameters set to pass or reject echoes returned from selected types of materials in the body.

The structural and motion signals produced by the B mode and Doppler processors are coupled to a scan converter 32 and a multi-planar reformatter 44. The scan converter 32 arranges the echo signals in the spatial relationship from which they were received in a desired image format. In other words, the scan converter acts to convert the RF data from a cylindrical coordinate system to a Cartesian coordinate system appropriate for displaying an ultrasound image on an image display 40. In the case of B mode imaging, the brightness of pixel at a given coordinate is proportional to the amplitude of the RF signal received from that location. For instance, the scan converter may arrange the echo signal into a two dimensional (2D) sector-shaped format, or a pyramidal three dimensional (3D) image. The scan converter can overlay a B mode structural image with colors corresponding to motion at points in the image field, where the Doppler-estimated velocities to produce a given color. The combined B mode structural image and color Doppler image depicts the motion of tissue and blood flow within the structural image field. The multi-planar reformatter will convert echoes that are received from points in a common plane in a volumetric region of the body into an ultrasound image of that plane, as described in US Pat. 6,443,896 (Detmer). A volume renderer 42 converts the echo signals of a 3D data set into a projected 3D image as viewed from a given reference point as described in US Pat. 6,530,885 (Entrekin et al.).

The 2D or 3D images are coupled from the scan converter 32, multi-planar reformatter 44, and volume renderer 42 to an image processor 30 for further enhancement, buffering and temporary storage for display on an image display 40. The imaging processor may be adapted to remove certain imaging artifacts from the final ultrasound image, such as: acoustic shadowing, for example caused by a strong attenuator or refraction; posterior enhancement, for example caused by a weak attenuator; reverberation artifacts, for example where highly reflective tissue interfaces are located in close proximity; and so on. In addition, the image processor may be adapted to handle certain speckle reduction functions, in order to improve the contrast of the final ultrasound image.

In addition to being used for imaging, the blood flow values produced by the Doppler processor 28 and tissue structure information produced by the B mode processor 26 are coupled to a quantification processor 34. The quantification processor produces measures of different flow conditions such as the volume rate of blood flow in addition to structural measurements such as the sizes of organs and gestational age. The quantification processor may receive input from the user control panel 38, such as the point in the anatomy of an image where a measurement is to be made.

Output data from the quantification processor is coupled to a graphics processor 36 for the reproduction of measurement graphics and values with the image on the display 40, and for audio output from the display device 40. The graphics processor 36 can also generate graphic overlays for display with the ultrasound images. These graphic overlays can contain standard identifying information such as patient name, date and time of the image, imaging parameters, and the like. For these purposes the graphics processor receives input from the user interface 38, such as patient name. The user interface is also coupled to the transmit controller 18 to control the generation of ultrasound signals from the transducer array 6 and hence the images produced by the transducer array and the ultrasound system. The transmit control function of the controller 18 is only one of the functions performed. The controller 18 also takes account of the mode of operation (given by the user) and the corresponding required transmitter configuration and band-pass configuration in the receiver analog to digital converter. The controller 18 can be a state machine with fixed states.

The user interface is also coupled to the multi-planar reformatter 44 for selection and control of the planes of multiple multi-planar reformatted (MPR) images which may be used to perform quantified measures in the image field of the MPR images.

This invention relates to the implementation of a variable gain in the analog front end receiver to implement time gain compensation. The analog front end receiver is shown as 12a. There may be a time gain compensation circuit for each transducer, or a time gain compensation circuit for all transducer elements, or a combination of these two approaches.

Figure 2 shows a known configuration of the parts of the ultrasound system relevant to this invention, namely the ultrasound transducer 8, the receive/transmit switch 16, the ultrasound transmit amplifier 50, and the ultrasound receive amplifier 52,54. The receive amplifier 52,54 comprises a low noise amplifier circuit 52 and a variable resistor 54 forming a negative feedback path of the amplifier circuit 52. This is used to program the gain to provide time gain control. The transmit/receive switch 16 selectively couples the ultrasound transducer 8 to the ultrasound receive amplifier and the ultrasound transmit amplifier. In this example, the transducer current is converted to an output voltage and the gain is programmed by the feedback resistor. The output voltage is the current multiplied by the feedback resistance.

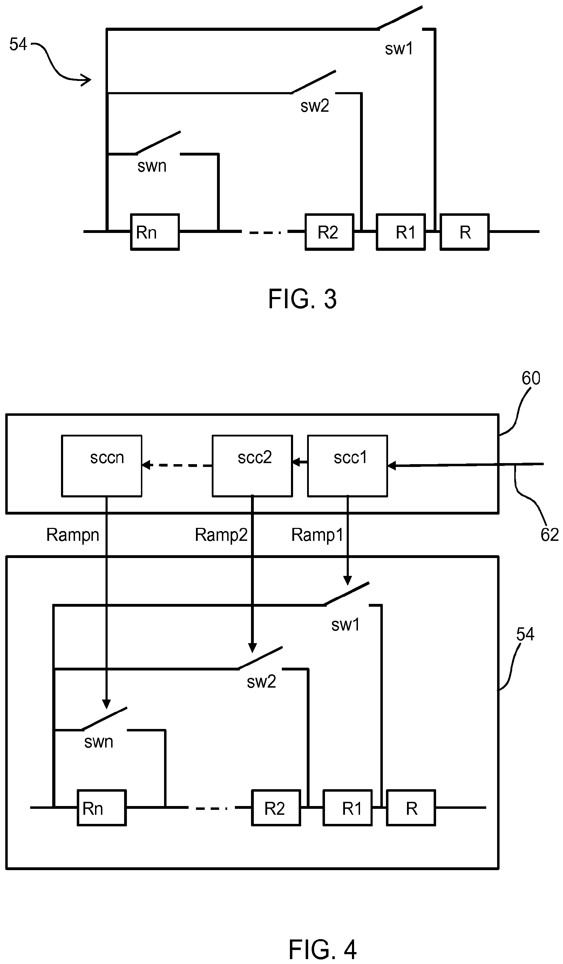

Figure 3 shows an example of the variable resistor 54. It comprises a resistor network having a series connection of resistors, including resistors R1-Rn each having an associated shorting switch sw1-swn. An additional first resistor R has no shorting switch and hence defines the lowest resistance level of the resistor network, and therefore defines the minimum gain. The more resistors that are connected in series in the negative feedback path, the higher the gain.

An infinite impedance, i.e. an open circuit, corresponds to an open loop amplifier and hence a maximum gain setting. A zero impedance, i.e. a short circuit, corresponds to a gain of 1, i.e. a minimum gain setting. Thus, the lowest impedance setting (only resistor R) corresponds to a lowest gain setting.

For example, if all switches are initially closed, the resistance is R. This corresponds to a minimum gain, when echoes are received from the near field. The gain is increased over time by introducing more and more of the resistors, i.e. by opening more and more of the switches, to reach a maximum gain when echoes are received from the far field.

When switch sw1 is opened, the resistance becomes R+R1.

When switch sw2 is then opened, the resistance becomes R+R1+R2.

Thus, the resistance may be incrementally increased by controlling the switches in sequence, and this provides an incremental increase in gain.

When applied to a known resistor network of the type shown in Figure 3, the invention provides a particular way to control the switches, thereby providing a time gain compensation circuit which implements the variable resistor 54 of Figure 2, in the feedback path of the receive amplifier.

In order to avoid image artefacts, the spectrum band of the echo signal should remain clean. It is therefore important to have a slow and gentle change in gain. Having staircase behavior for example would generate higher frequency spurs in the spectrum which will distort the received signal. In particular, by controlling the switches sw1-swn digitally over time, the curve of the resistance value over time will show such a staircase behavior and the gain will therefore also suffer from this behavior. Slowing down the signal that controls the switches can be used to reduce the staircase behavior but would lead to a slow start up time.

Figure 4 shows the time gain compensation circuit according to one example of the invention.

It shows the same variable resistor 54 of Figure 3. Each switch sw1-swn has its own switch control circuit scc1-sccn. In a simplest implementation, each switch is just a series NMOS transistor.

The first switch control circuit scc1 is initiated by a trigger signal 62 in order to open the switch, from an initially closed state. Each subsequent switch control circuit scc2-sccn is initiated by a signal from the preceding switch control circuit.

Each switch control circuit generates a ramp signal Ramp, 1-Ramp,n for controlling the switching of the respective shorting switch. The ramp signal is designed to provide progressive switching of the respective shorting switch. By this is meant that the switching is not implemented as quickly as the switch technology allows, but is deliberately prolonged to provide a gradual change in output impedance of the shorting switch, so a gradual increase in resistance (when the switch is opened).

As explained further below, some or all of the switch control circuits comprise a ramp generator for generating a first ramp signal during an initial ramp period and a second, less steep, ramp signal during a following ramp period. The use of two ramp signals enables a shallow ramp to be used to implement the desired progressive switching function whereas a steep ramp avoids a long delay from the initial startup of the time gain compensation circuit until the progressive switching is initiated. In this way, the gain has a more linear response over time but a long start up time period is avoided. This provides a desired compromise between distortion, delay and image artefacts.

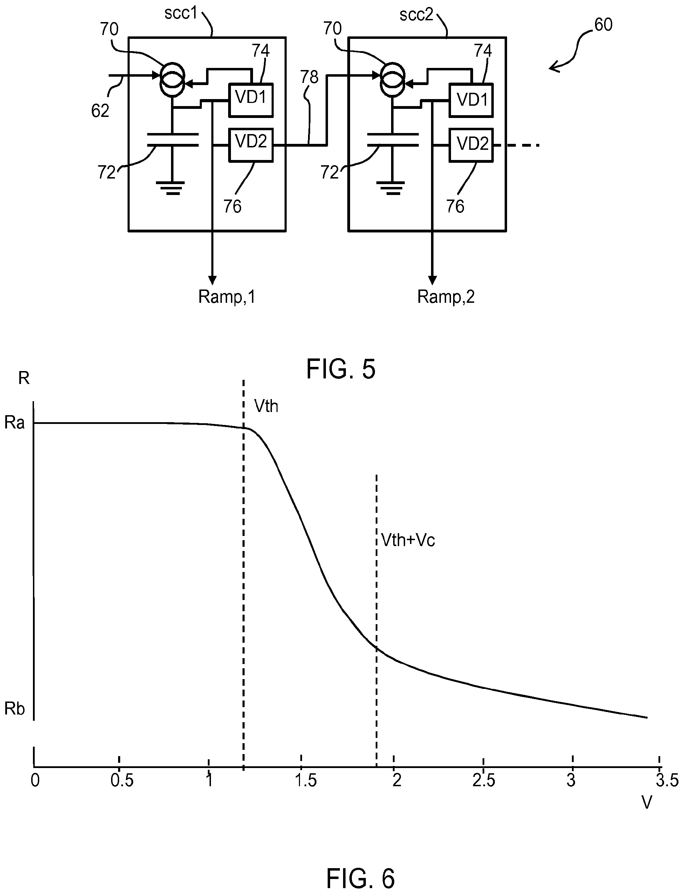

Figure 5 shows one example of the first two switch control circuits scc1, scc2.

Each switch control circuit comprises a controllable current source 70 and a capacitor 72 which is charged or discharged by the current from the controllable current source. In one example, as explained above, the switches are all initially closed, and they are opened in a sequence. For a switch such as an n-type transistor, the switch is closed by a high gate signal, and by discharging the gate the switch will close. In such a case, the capacitor is discharged from an initially charged state by the current source to open the switch at a later time.

The discharge current is controllable between two values in this example, by a controller 74. The different current settings result in different voltage versus time slopes. The controller 74 for example comprises a level detector (in particular a voltage detector with detection voltage VD1), for detecting a voltage of the first ramp signal for switching from the first current to the second current.

In this way, when the first ramp signal is approaching the level at which the progressive switching will take place, the ramp slope is reduced, so that the switching function is made more gradual.

The second switch control circuit scc2 is initiated by a signal 78 from a preceding, i.e. first, switch control circuit scc1 (but not necessarily the immediately preceding switch control circuit). As shown, a second level detector circuit 76 (in particular a voltage detector with detection voltage VD2) is used to provide the initiation trigger to the second switch control circuit scc2.

The second level detector may be for detecting a level of the first or second ramp signal, depending on the time at which the next switch control circuit is to be triggered. A single start signal 62 may be provided, and the circuit then implements a sequential operation of the switch control circuits to achieve the desired gain function with respect to time.

Figure 6 shows a plot of the feedback resistance (y-axis) varying from Ra to Rb when one switch voltage value (x-axis) is varied using the ramp signal. The impedance increases when the ramp signal transitions from high to low.

The impedance changes quickly in the 1.2V to 1.8V range. This is where a slow ramp signal may be used to slow down the switching process such that the impedance changes linearly, i.e. smoothly.

The threshold voltage Vth is the threshold voltage of the switch (an NMOS transistor in this example). The voltage where the slow ramp starts operating is Vth+Vc. Vc is the voltage range where the switch is in transition. Thus, the slow ramp voltage is used below Vth+Vc and the fast ramp voltage is used above Vth+Vc. The time duration while the voltage is in the range Vth to Vth+Vc is thus extended by using the slow ramp signal. For example, the duration may be more than 5ns, for example more than 10ns, for example more than 20ns. Thus, a significant portion of the overall time gain compensation time period is taken up by operation of the switches in the voltage range Vth to Vth+Vc, such as at least 10%, or at least 20% or at least 30% of the overall time duration. Vc is for example in the range 0.5V to 1.5V.

The overall time when the first ramp starts and when the last ramp finishes is the overall time gain compensation time. This time can be tunable depending on the application. In this example, the time is 3µs. However, it could be lower, for example 500ns.

The time duration of the individual ramps will depend on the overall time gain compensation period.

The current that sets the ramp slope is reduced when switching to the slow ramp mode. The ratio of the currents can be tuned such that the change of impedance remains substantially linear with respect to time. For example, the fast ramp slope may be 5 times steeper than the slow ramp slope.

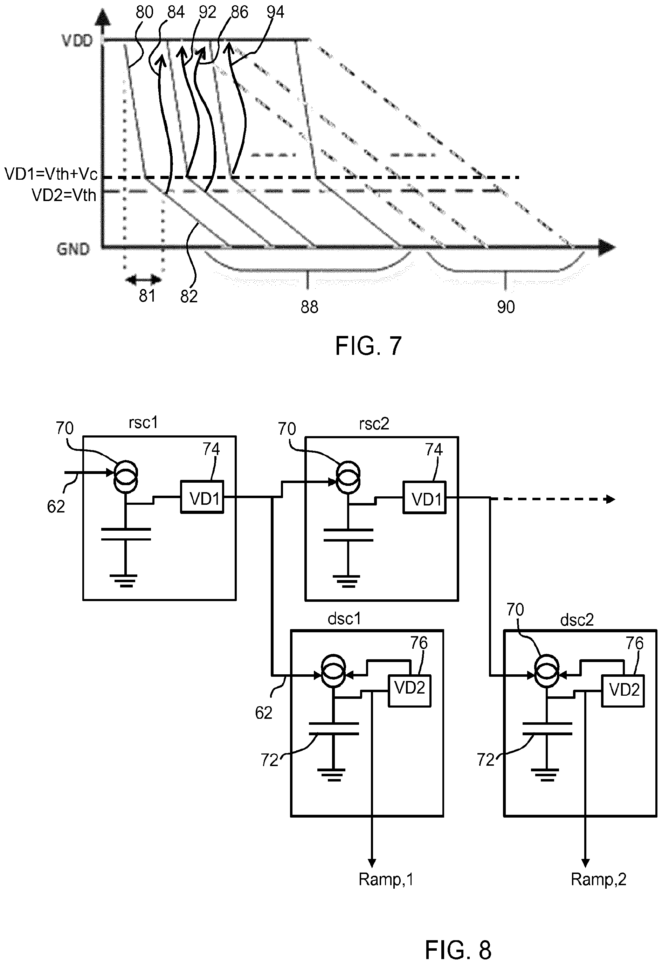

Figure 7 shows the capacitor voltages over time for a set of switch control circuits. The voltage function for the first switch control circuit scc1 has a first ramp signal 80 during an initial ramp period. This has a steep slope to minimize a startup time 81. There is then a second, less steep, ramp signal 82 during a following ramp period. The transition between the two slopes is at the detection voltage VD1 (=Vth+Vc in Figure 6). This is at the kink between the two slopes.

The threshold voltage Vth for the switch circuits sw1-swn is just below the detection voltage VD1 so that the switching (in particular off) takes place during the lower slope portion of the ramp signal. The second ramp signal crosses the switching threshold Vth of the transistor so that operation is in the linear region.

Figure 7 shows the detection voltage VD2 used to provide sequential operation of the switch control circuits. In this example, it is the same as the threshold voltage Vth, but this is just to simplify the drawing. The threshold levels will be selected so that the resulting overall feedback resistance versus time has the desired profile. The thresholds may the same for each switch control circuit or they may be different.

When the voltage ramp for the first switch control circuit scc1 reaches the second voltage threshold VD2, the next switch control circuit is triggered as shown by arrow 84. Similarly, when the voltage ramp for the second switch control circuit reaches the second voltage threshold VD2, the next switch control circuit is triggered as shown by arrow 86.

There are different ways to control the switch control circuits.

Figure 8 shows another possible example in which there are two types of control block, a driving switch control block dsc and a reference switch control block rsc which is a copy of the driving switch control block. This reference blocks generate ramps but they have a fixed internal capacitor. Each reference switch control block generates a digital trigger signal that controls the driving switch control block.

The timing of the triggers is in this way made more stable because it is derived from ramps that are generated by a current into a fixed capacitor. The driving ramps also use a fixed capacitor (which may be different to the capacitor used in the reference blocks) but they also see the load of the interconnections and the switch. The feedback resistor and its switch is for example next to the low noise amplifier, so some interconnecting lines are needed.

An alternative is to make use of a simple internal clock to control in very accurate way the timing of each ramp. The disadvantage is that this clock might couple to the receive signal and create some undesired behavior.

The ramps that drive the switches will have different loads (as a result of different circuit component layouts and routing). Also, the comparator that triggers on the second threshold VD2 may have some spread which will be converted to a time spread and may therefore accumulate when switching from one ramp to another. To compensate for this, the exact moment of switching from fast to slow may be compensated by making the threshold VD2 tunable.

Returning to Figure 7, in this example there is a set of switch control circuits and hence voltage ramps 88 which operate in the way explained above. However, later switch control circuits can have a single ramp slope since they do not contribute to the startup time. These are shown as voltage ramps 90.

In this case, there is a first sub-set of shorting switches and an associated first sub-set of switch control circuits which implement a double ramp and a second sub-set of shorting switches and an associated second sub-set of switch control circuits which implement a single ramp.

The timing of the voltage ramps in the set 90 is different. As shown by arrow 92, in this example the first voltage threshold VD1 of the second switch control circuit scc2 is used to trigger the first in the set 90 (which is not the next in the series of switch control circuits, but is several further ahead). The next trigger event is shown by arrow 94.

Thus, the trigger system for the section 90 is less simple than for the section 88. A suitable one of the ramps in the section 88 can be used as the reference point, as explained above. There is a minimum set of ramps of the first section 88 before progressing to the second section 90.

The second section 90 is however optional, and the dual slope design only may be used. The timing of the sequential operation of all of the switch control circuits is designed to achieve the desired overall response over time.

The switch control circuits may all be identical but may be configurable to provide a single ramp or a dual ramp. There may be multiple voltage detectors, and the connection between the circuits (e.g. 78 in Figure 5), and the voltages at which the trigger signals are generated, defines the overall timing.

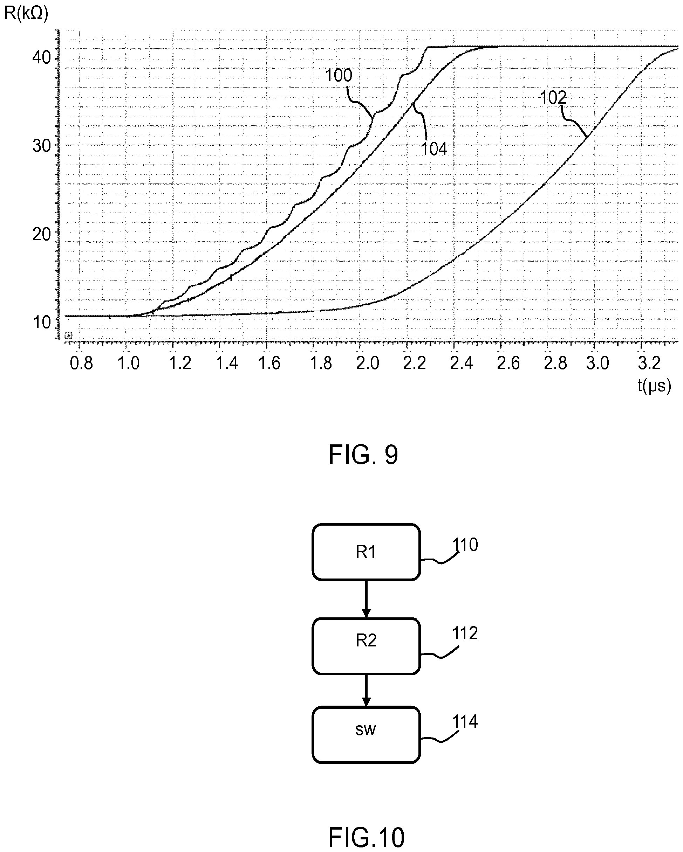

Figure 9 shows the overall impedance of the feedback resistor over time for different cases.

Plot 100 is based on all ramps having a single steep slope. Plot 102 is based on all ramps having a single shallow slope. Plot 104 shows the approach of the invention in which a first one or more switch control circuits implement a dual slope, in this example followed by a set of slow slopes (which is an optional example).

It can be seen that the use only of steep slopes shows a staircase behavior similar to a digital hard switching approach. The use only of shallow slopes provides a more linear response but with a long start-up delay.

Plot 104 shows that the invention enables a linear behavior while keeping the start-up time short.

The advantage of using single ramps for the later switch control circuits is that the amount of switching during the transition time is reduced, thereby reducing disturbances.

Figure 10 shows a time gain compensation method for an ultrasound system, comprising, for at least one of the switch control circuits. It comprises:
in step 110, generating a first ramp signal during an initial ramp period;
in step 112, generating a second, less steep, ramp signal during a following ramp period; and
in step 114, controlling the switching of the shorting switch using the second ramp signal.

In the examples above, the feedback resistor is shown as a simple series connection of resistors. Other topologies may be used, with series and/or parallel resistor configurations. The general approach is to switch a resistor into the circuit or out of the circuit, within an amplifier feedback system. The switches may be based on PMOS switches instead of NMOS switches.

The shorting switches are all connected to the start of the configurable series (i.e. the junction between R and R1). However, this is equivalent to a switch in parallel with each individual resistor (since the switches are operated in sequence, so that one extra switch is closed or opened at a time).

The switches are typically individual transistors, but more complex transistor circuits may be used. It is of course desirable that the on resistance of the switches (which of course is non-zero in practice) has the least impact on the circuit performance, or indeed is taken into account when selecting the resistor values.

The example above is based on a daisy chain type control approach, whereby the circuit determines its own timing once initiated and the control is based on discrete components. However, there could equally be independent control signals applied to each switch control circuit. The control may then for example be implemented by an ASIC or a controller which is configurable by software.

There are for example between 5 and 25 switch control circuits and resistors, to provide a smooth resistance function but with relatively simple circuitry. The higher the number the better the step resolution. There may be two or more time gain compensation circuits in series.

The example above has a switch for each resistor. Of course, one switch may be associated with a set of resistors. As also shown, not all resistors need a shorting switch, since the feedback path will have a non-switched resistor to define the minimum feedback resistance (corresponding to the maximum gain).

The examples above are based on generating a ramp voltage using charging/discharging a capacitor at a controllable rate. An RC network may instead be used. The switch control circuits may all be the same, wherein a first set can be configured to operate in dual slope mode while the rest are configured to operate in slow mode. The number in each set can be configurable.

The created slope, as shown in Figure 9, may be linear or the shape can be adapted to a specific case. Different ramps could have the same or different settings.

The invention is of interest for ultrasound imaging generally, which may be for external imaging or for internal examination such as in intravascular ultrasound (IVUS).

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. s. The mere fact that certain measures are recited in mutually different dependent claims does not indicate that a combination of these measures cannot be used to advantage. The software mentioned above may be stored/distributed on a suitable medium, such as an optical storage medium or a solid-state medium supplied together with or as part of other hardware, but may also be distributed in other forms, such as via the Internet or other wired or wireless telecommunication systems. If the term "adapted to" is used in the claims or description, it is noted the term "adapted to" is intended to be equivalent to the term "configured to". Any reference signs in the claims should not be construed as limiting the scope.

## Claims

1. A time gain compensation circuit for an ultrasound imaging system, comprising:
a resistor network for forming a negative feedback path of a ultrasound receive amplifier, wherein the resistor network comprises a set of resistors (R1-Rn) and a set of shorting switches (sw1-swn) each for shorting a respective one or ones of the resistors;
a switch control circuit (scc1-sccn) for each shorting switch for generating a ramp signal (Ramp,1, Ramp,2, Ramp,3) for providing progressive switching of the respective shorting switch,
wherein at least one of the switch control circuits comprises:
a ramp generator for generating a first ramp signal (80) during an initial ramp period and a second, less steep, ramp signal (82) during a following ramp period, wherein the second ramp signal controls the switching of the shorting switch (sw1-swn).

2. A circuit as claimed in claim 1, wherein the at least one of the switch control circuits comprises:
a controllable current source (70);
a capacitor (72) which is charged or discharged by the current from the controllable current source; and
a controller (74) for controlling the current source to operate at a first current to generate the first ramp signal and at a second, lower, current to generate the second ramp signal.

3. A circuit as claimed in claim 2, wherein the at least one of the switch control circuits comprises:
a level detector (74) for detecting a level of the first ramp signal for switching from the first current to the second current.

4. A circuit as claimed in claim 2 or 3, wherein the resistor network comprises a series connection of resistors (R1-Rn), each having an associated shorting switch (sw1-swn) and switch control circuit (scc1-sccn), wherein each switch control circuit is initiated by a signal from a preceding switch control circuit.

5. A circuit as claimed in claim 4, wherein the at least one of the switch control circuits (scc2-sccn) comprises a second level detector (76) for detecting a level of the first or second ramp signals for triggering the initiation of a subsequent switch control circuit.

6. A circuit as claimed in any one of claims 1 to 5, comprising:
a first sub-set of shorting switches and an associated first sub-set of switch control circuits which comprise said at least one of the switch control circuits; and
a second sub-set of shorting switches and an associated second sub-set of switch control circuits, wherein the second sub-set of switch control circuits each comprise a ramp generator for generating a single ramp signal.

7. A circuit as claimed in any one of claims 1 to 6, wherein each shorting switch comprises a transistor or a transistor circuit, wherein the second ramp signal crosses the switching threshold of the transistor or transistor circuit.

8. An ultrasound receive amplifier, comprising:
an amplifier circuit (52); and
a time gain compensation circuit as claimed in any one of claims 1 to 7, with the resistor network of the time gain compensation circuit forming a negative feedback path of the amplifier circuit.

9. An ultrasound transceiver, comprising:
an ultrasound receive amplifier as claimed in claim 8;
an ultrasound transmit amplifier (50); and
a transmit/receive switch (16) for selectively coupling an ultrasound transducer to the ultrasound receive amplifier and the ultrasound transmit amplifier.

10. An ultrasound system, comprising:
an ultrasound transceiver as claimed in claim 9; and
an ultrasound transducer (8) coupled to the ultrasound receive amplifier and the ultrasound transmit amplifier through the transmit/receive switch.

11. A time gain compensation method for an ultrasound system, comprising:
generating ramp signals using switch control circuits, wherein each switch control circuit is associated with a respective shorting switch for shorting a respective resistor or resistors of a resistor network forming a negative feedback path of an ultrasound receive amplifier;
wherein for at least one of the switch control circuits, the method comprises:
(110) generating a first ramp signal during an initial ramp period;
(112) generating a second, less steep, ramp signal during a following ramp period; and
(114) controlling the switching of the shorting switch using the second ramp signal.

12. A method as claimed in claim 11, wherein for said at least one of the switch control circuits, the method comprises:
controlling a current source to operate at a first current to generate the first ramp signal and at a second, lower, current to generate the second ramp signal; and
charging or discharging a capacitor using the current from the controllable current source.

13. A method as claimed in claim 11, wherein the resistor network comprises a series connection of resistors, each having an associated shorting switch and switch control circuit, wherein the method comprises initiating each switch control circuit by a signal from a preceding switch control circuit.

14. A method as claimed in any one of claims 11 to 13, wherein said at least one of the switch control circuits comprises a first sub-set of switch control circuits and the method comprises, for a second sub-set of shorting switches, generating a single ramp signal.

15. A method as claimed in any one of claims 11 to 14, wherein each shorting switch comprises a transistor or a transistor circuit, wherein the method comprises generating the second ramp signal to cross the switching threshold of the transistor or transistor circuit.
